# FASCICULE DE BREVET EUROPEEN

(11) **EP 2 686 888 B1**
(45) Date de publication et mention de la délivrance du brevet: **27.05.2015**
(21) Numéro de dépôt: 12712288.5
(22) Date de dépôt: 06.03.2012
(51) Int. Cl.: H01L 21/20, H01L 31/0352, H01L 31/0224, H01L 31/0312, H01L 31/074, H01L 29/06, H01L 29/12, B82Y 10/00, B82Y 20/00, B82Y 40/00

(54) **DISPOSITIF À BASE DE NANO/MICROFILS STABILISÉ MÉCANIQUEMENT ET AUX PROPRIÉTÉS OPTIQUES AMÉLIORÉES ET SON PROCÉDÉ DE RÉALISATION.**
MECHANISCH STABILE VORRICHTUNG AUF BASIS VON NANO-/MIKRODRÄHTEN UND MIT VERBESSERTEN OPTISCHEN EIGENSCHAFTEN SOWIE VERFAHREN ZU IHRER HERSTELLUNG
MECHANICALLY STABLE DEVICE BASED ON NANO/MICRO WIRES AND HAVING IMPROVED OPTICAL PROPERTIES AND PROCESS FOR PRODUCING IT

(30) Priorité: 17.03.2011 FR 1100804
(43) Date de publication de la demande: 22.01.2014
(73) Titulaire: Commissariat à l'Énergie Atomique et aux Énergies Alternatives, 75015 Paris (FR)
(72) Inventeur: KOHEN, David, F- 69100 Villeurbanne (FR); KARST, Nicolas, F- 57600 Folkling (FR); PERRAUD, Simon, F- 83150 Bandol (FR)
(74) Mandataire: Talbot, Alexandre
(86) Numéro de dépôt international: PCT/FR2012/000078
(87) Numéro de publication internationale: WO 2012/123649

(56) Documents cités:
- LUWEI SUN ET AL: "Controllable growth and optical properties of ZnO nanostructures on Si nanowire arrays", CRYSTENGCOMM, ROYAL SOCIETY OF CHEMISTRY, CAMBRIDGE, GB, vol. 13, no. 7, 1 février 2011 (2011-02-01), pages 2439-2444, XP009153391, ISSN: 1466-8033, DOI: 10.1039/C0CE00844C [extrait le 2011-02-01]
- CHEN-HAO KU ET AL: "Wet-Chemical Route to ZnO Nanowire-Layered Basic Zinc Acetate/ZnO Nanoparticle Composite Film", CRYSTAL GROWTH & DESIGN, vol. 8, no. 1, 1 janvier 2008 (2008-01-01) , pages 283-290, XP055010617, ISSN: 1528-7483, DOI: 10.1021/cg070461x cité dans la demande

## Description

### Domaine technique de l'invention

L'invention concerne un dispositif comprenant de fils de dimensions nanométriques ou micrométriques et formés par un matériau semi-conducteur choisi parmi le silicium, le germanium et un alliage de silicium et de germanium, son procédé de réalisation et son utilisation dans une cellule photovoltaïque ou un composant photonique.

### État de la technique

Les nanofils ou microfils en matériau semi-conducteur présentent des propriétés mécaniques, optiques et électriques les rendant attractifs dans de nombreux domaines technologiques. Ces dernières années, ils ont été intensément étudiés dans des domaines tels que les domaines de l'électronique, de l'optoélectronique et des capteurs. De plus, récemment, ils sont utilisés dans des dispositifs de récupération d'énergie tels que des dispositifs convertissant l'énergie thermique, mécanique ou solaire en électricité. En particulier, un domaine prometteur pour les structures à base de fils semi-conducteurs est le domaine photovoltaïque.

L'article de Luwei Sun et al. "Controllable growth and optical properties of ZnO nanostructures on Si nanowire arrays", CrystEngComm 13, 2439 (2011) décrit une méthode pour produire des nanofils de Si comportant des billes de ZnO disposées à la surface des fils.

L'article « Challenges and Prospects of Nanopillar-Based Solar Cells » de Zhiyong Fan et al. (Nano Res (2009) 2 : 829-843) résume les progrès continus du photovoltaïque à base de nanofils (également notés par l'acronyme anglo-saxon « NWs » pour « nanowires »), en vue de son intégration pour des modules de cellules solaires efficaces et abordables.

Parmi les différentes structures photovoltaïques passées en revue dans l'article de Zhiyong Fan et al., on peut citer un nouveau type de cellules solaires à colorant (« DSSC » pour le terme anglo-saxon « Dye-sensitized solar cell ») dans lequel le film de nanoparticules d'oxyde de titane (TiO₂) ou d'oxyde de zinc (ZnO) est remplacé par un tapis de nanofils d'oxyde de zinc monocristallins orientés verticalement. Cependant, l'article de Zhiyong Fan et al. indique que les cellules DSSCs à base de nanofils restent encore inférieures aux meilleures cellules DSSCs à base de nanoparticules, même lorsqu'elles sont recouvertes d'un revêtement de surface destiné à améliorer le rendement des cellules DSSCs.

À titre d'exemple, l'article « Wet-Chemical Route to ZnO Nanowire-layered Basic Zinc Acetate/ZnO Nanoparticle Composite Film » de Chen-Hao Ku et al. (Crystal Growth & Design, 2008, Vol. 8, N°1, 283-290) synthétise et étudie un film composite formé par un tapis de nanofils d'oxyde de zinc couvert d'un film noté LBZA/ZnO NPs et composé de nanoparticules d'oxyde de zinc et d'acétate de zinc hydroxydé, aussi connu sous l'acronyme français AZH ou anglais LBZA. Le film de LBZA/ZnO NPs est réalisé par immersion du tapis de nanofils d'oxyde de zinc dans une solution de méthanol et d'acétate de zinc, à 60°C pendant une durée variant de 14 heures à 24 heures. Des mesures photovoltaïques montrent qu'un tel film composite pourrait être un candidat prometteur comme photoanode dans une cellule DSSC, pour une durée d'immersion du tapis de nanofils, dans le bain chimique, inférieure à 15 heures. La formation du film composite semble reposer sur une nucléation hétérogène de la structure de LBZA à la surface cristalline des nanofils de ZnO. Au-delà de 15 heures d'immersion, il se produit une nucléation secondaire de LBZA à la surface du film composite formé par le tapis de nanofils de ZnO et le film de LBZA/ZnO NPs, qui provoque un déclin dans les performances photovoltaïques du film composite.

L'article de Zhiyong Fan et al. précité mentionne également des cellules solaires inorganiques à base de nanofils, en particulier, à base de silicium. Il rapporte que, bien que le silicium est un matériau dominant dans les cellules solaires planes conventionnelles, il n'est pas un matériau idéal pour les cellules solaires à base de nanofils, du fait de son faible coefficient d'absorption optique et de sa bande interdite étroite.

De plus, les dispositifs à base de nanofils et notamment à base de nanofils en matériaux semi-conducteurs tels que le silicium, sont des structures fragiles, sans tenue mécanique, ce qui rend leur manipulation compliquée. Par ailleurs, l'espace entre les nanofils ne participe pas à l'absorption optique et peut être considéré comme perdu. Enfin, le contact électrique entre tous les nanofils doit être établi pour réaliser un dispositif fonctionnel.

Dans l'article « Enhanced absorption and carrier collection in Si wire arrays for photovoltaic applications » de Michaels D. Kelzenberg et al. (Nature Materials 9, 239-244 (2010)), les propriétés d'absorption optique de structures comprenant des nanofils en silicium obtenus par dépôt chimique en phase vapeur sont étudiées. En particulier, des nanofils de silicium sont obtenus par un procédé de croissance Vapeur Liquide Solide (« VLS »), puis enrobés dans un film en PDMS (polydiméthylsiloxane). Pour améliorer l'absorption optique, il est notamment proposé de réaliser un dépôt conforme anti-réflecteur en SiNₓ sur les sommets et les côtés des nanofils avant l'encapsulation dans le PDMS et/ou d'ajouter des particules d'alumine dans le film en PDMS pour que les particules diffusent la lumière vers les nanofils. Cependant, les solutions proposées dans cet article, notamment pour améliorer l'absorption optique, ne sont pas entièrement satisfaisantes. En effet, le PDMS et les particules d'alumine sont des matériaux isolants électriquement. Ainsi, la conduction électrique dans ce type de structures ne peut se faire que par les sommets des nanofils en silicium. De plus, le procédé de fabrication de ces structures est long et coûteux, surtout pour des structures de grande surface.

### Objet de l'invention

L'objet de l'invention consiste à proposer un dispositif comprenant une pluralité de fils de dimensions nanométriques ou micrométriques, formés par un matériau semi-conducteur choisi parmi le silicium, le germanium et un alliage de silicium et de germanium, remédiant aux inconvénients de l'art antérieur. En particulier, l'objet de l'invention est de proposer un dispositif présentant une stabilité mécanique et des propriétés optiques améliorées, avec la capacité d'avoir une conduction électrique améliorée.

Selon l'invention, cet objet est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 4 représentent, schématiquement et en coupe, différentes étapes de réalisation d'un dispositif comprenant un tapis de fils de silicium verticaux, entourés de billes de ZnO.
- la figure 5 est un cliché obtenu par microscopie électronique à balayage avec un grossissement x 6000 d'un dispositif comprenant un tapis de fils de silicium verticaux.
- la figure 6 est un cliché obtenu par microscopie électronique à balayage avec un grossissement x 4000 d'un dispositif comprenant un tapis de fils de silicium verticaux, entourés de billes de ZnO.
- la figure 7 est un cliché obtenu par microscopie électronique à balayage avec un grossissement × 80000 des billes de ZnO visibles sur le cliché selon la figure 6.
- la figure 8 illustre, schématiquement et en coupe, une cellule photovoltaïque comprenant un dispositif comprenant un tapis de fils de silicium verticaux et entourés de billes de ZnO réparties de manière homogène le long des fils.
- la figure 9 représente l'évolution du courant en fonction de la tension pour une cellule photovoltaïque comprenant un dispositif avec un tapis de fils de silicium sans billes de ZnO (figure 9A) et avec billes de ZnO (Figure 9B).

### Description de modes préférentiels de l'invention

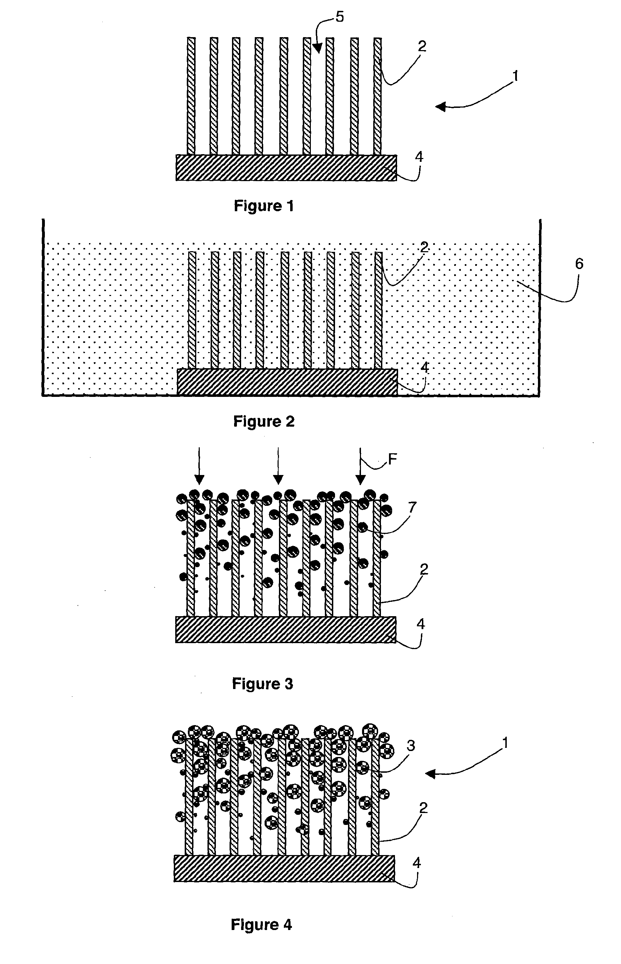

Comme illustré sur les figures 1 à 4, un dispositif 1 comprenant une pluralité de fils 2 est traité par voie humide et par recuit, afin de former des billes 3 en ZnO à la surface des fils 2.

Les fils 2 sont formés par un matériau semi-conducteur choisi parmi le silicium, le germanium et un alliage de germanium et de silicium. Le matériau semi-conducteur peut être avantageusement dopé électroniquement de type n ou p, selon les applications du dispositif. Les fils 2 sont, plus particulièrement, des fils ayant des dimensions nanométriques (nanofils) et/ou micrométriques (microfils). Ils ont, par exemple, un diamètre compris entre 5nm et 10µm et une longueur de l'ordre de 500nm à 100µm.

De plus, les fils peuvent avoir une structure cristalline, par exemple monocristalline ou polycristalline. Ils peuvent aussi être de structure amorphe (a-Si) éventuellement hydrogénée (notée a-Si :H), c'est-à-dire avec un fort taux d'hydrogène, par exemple compris entre 1% et 20%.

La structure des fils dépend essentiellement de la méthode de réalisation utilisée. À titre d'exemple, les fils peuvent être obtenus par un procédé de croissance vapeur-liquide-solide (dépôt CVD assisté par un catalyseur métallique comme l'aluminium ou l'or), par gravure chimique ou physique, par épitaxie par jet moléculaire. Ils sont, alors, de structure monocristalline ou polycristalline. Ils peuvent aussi être obtenus par gravure, par exemple par gravure ionique réactive (RIE pour « Reactive-Ion Etching »), d'une couche constituée par le matériau semi-conducteur choisi pour former les fils. Dans ce cas, les fils seront de structure amorphe ou cristalline, selon la structure du matériau semi-conducteur constituant la couche destinée à être gravée.

Lorsque les fils ont une structure cristalline, de manière connue, leur surface s'oxyde très facilement au contact de l'air. Ainsi, un oxyde superficiel (oxyde natif) est formé à la surface des fils et il présente une structure amorphe. Dans ce cas, l'oxyde amorphe à la surface des fils est, préférentiellement, conservé pour la réalisation des billes 3.

Par conséquent, dans le cas de fils de structure cristalline comme dans le cas de fils de structure amorphe, les billes 3 sont, de manière avantageuse, formées et donc disposées sur une surface amorphe des fils.

Selon une alternative, une couche en matériau semi-conducteur amorphe peut aussi être déposée à la surface d'au moins une partie des fils. Dans ce cas, les fils peuvent être soit de structure cristalline, soit de structure amorphe, selon les applications. Le dépôt est, par exemple, un dépôt conforme de silicium amorphe hydrogéné, réalisé par exemple par PECVD (« Plasma Enhanced Chemical Vapor Deposition »). Dans ce cas, les billes 3 sont aussi formées (et donc disposées) sur une surface amorphe. Cette surface est aussi considérée comme la surface des fils.

Ainsi, de manière générale, la surface à partir de laquelle sont formées les billes 3 en ZnO est préférentiellement amorphe.

Sur les figures 1 à 4, les fils 2 sont supportés par un substrat 4, qui peut être en matériau semi-conducteur ou métallique. Ils sont, de plus, arrangés verticalement par rapport au substrat 4. Cependant, la direction de croissance des fils pourrait, selon les applications, être différente. Elle pourrait être par exemple aléatoire ou bien dans toutes les directions de croissance existantes. Par ailleurs, compte tenu du caractère conforme du dépôt de ZnO, les fils pourraient aussi présenter des coudes ou des changements de direction. Enfin, les fils 2 sont séparés les uns des autres par des espaces 5 ayant une largeur moyenne, avantageusement, comprise entre 100nm et 15µm et, préférentiellement, comprise entre 100nm et 1µm.

Les billes 3 sont formées à la surface, avantageusement amorphe, des fils 2 et une partie desdites billes 3 occupe les espaces 5 séparant les fils 2. Ces billes 3 sont obtenues par immersion des fils 2 dans un bain contenant un solvant et de l'acétate de zinc, dans des conditions de température et de pression maintenant le solvant à l'état liquide. Avantageusement, l'immersion des fils dans le bain est réalisée sans agitation.

La figure 2 illustre cette étape d'immersion des fils 2 dans un bain 6 contenant l'acétate de zinc en solution. L'acétate de zinc peut être dilué, avec par exemple une concentration comprise entre 0,01 et 0,5 mol/L ou bien le bain 6 peut être rempli d'une solution saturée en acétate de zinc. Dans les deux cas, le solvant utilisé est un solvant alcoolique, tel que du méthanol ou de l'éthanol. De plus, l'étape d'immersion est, en particulier, réalisée dans une enceinte scellée, à pression atmosphérique et en maintenant le bain à une température comprise entre -10°C et +65°C. Par ailleurs, la durée de l'étape d'immersion est, de préférence, comprise entre 2 heures et 48 heures, notamment pour une solution comprenant une concentration en acétate de zinc comprise entre 0,01 et 0,5mol/L. La durée de l'étape d'immersion peut être diminuée en renouvelant régulièrement le bain chimique, par exemple toutes les heures.

Une telle étape d'immersion permet d'accrocher à la surface des fils 2 des particules 7 d'acétate de zinc hydroxydé, également connu sous l'acronyme anglo-saxon LBZA et répondant à la formule Zn(OH)ₓ-(CH₃COO₂)_{y}•H₂O).

Comme illustré sur la figure 3, le dispositif comprenant les fils 2 avec les particules 7 de LBZA est, ensuite, retiré du bain 6 et il subit un recuit thermique destiné à transformer les particules 7 en LBZA en billes 3 à base d'oxyde de zinc. Le recuit thermique est symbolisé par les flèches F sur la figure 3. Il est, avantageusement, réalisé à une température comprise entre 300°C et 600°C. Le recuit thermique est, par exemple, réalisé avec une montée en température progressive selon une rampe de 80°C/minute jusqu'à une stabilisation à une température de 450°C pendant 10 minutes.

Le recuit thermique permet d'obtenir les billes 3 à la surface des fils 2. De plus, il a été trouvé que les billes 3 sont chacune composées par un agglomérat de particules d'oxyde de zinc. Cet agglomérat est sphérique et il peut être creux ou plein. Les particules d'oxyde de zinc sont des nanoparticules d'oxyde de zinc ayant, en particulier, un diamètre compris entre 10nm et 200nm et, avantageusement, compris entre 100nm et 200nm. De plus, comme illustré sur la figure 4, les billes 3 peuvent avoir des diamètres variables, compris dans une fourchette allant de 100nm à 1µm. Les particules d'oxyde de zinc constituant ces billes 3 ont alors elles aussi des diamètres variables dans la gamme de 10nm à 200nm, tout en restant toujours inférieur au diamètre de la bille qu'elles constituent. Ainsi, les particules d'oxyde de zinc formant par agglomération une bille ayant un diamètre de 100nm ont nécessairement un diamètre inférieur à 100nm. Il peut, par exemple, être comprise dans une fourchette de 10nm à 50nm.

Il a aussi été constaté que la morphologie particulière des billes 3 est obtenue avant le recuit. En effet, les particules 7 en LBZA présentent, avant le recuit, la morphologie particulière des billes 3 : les particules 7 sont elles aussi constituées d'agglomérats de particules de LBZA de plus petites dimensions. Par contre, les particules 7 en LBZA ont des dimensions plus petites que les billes 3. Leur diamètre est avantageusement inférieur de 40% à 75% que celui des billes 3 obtenues après le recuit. Il en est de même pour les particules de plus petites dimensions (nanoparticules en LBZA) constituant les particules 7 en LBZA par rapport aux nanoparticules d'oxydes de zinc. Les nanoparticules en LBZA ont, en particulier, un diamètre variable compris dans la fourchette suivante : 4nm-150nm.

Par ailleurs, comme illustré sur la figure 4, les billes 3 ont été formées par croissance à partir de la surface, avantageusement amorphe, des fils 2. Ainsi, sur la figure 4, la répartition des billes est localisée. Une partie des billes 3 est disposée dans les espaces 5, tandis qu'une autre partie des billes 3 peut être disposée au sommet des fils 2.

Selon une alternative, la répartition des billes 3 le long des fils 2 pourrait être différente. Elle pourrait être homogène le long des fils, dans les espaces les séparant. Ceci permettrait alors d'obtenir un effet optique amélioré. Une telle répartition homogène peut être obtenue en modifiant les dimensions des fils, leur espacement et de la concentration en acétate de zinc dans le bain chimique.

Enfin, la densité et la disposition des billes 3 permettent, avantageusement, de mettre des nanofils adjacents en contact les uns avec les autres, ce qui peut autoriser une connexion électrique entre les nanofils, notamment lorsque les propriétés de conduction électronique des billes 7 sont modifiées. Ceci est particulièrement avantageux dans de nombreux domaines d'applications, tels que le domaine des cellules photovoltaïques, à jonction radiale ou axiale, ou même le domaine des composants photoniques. Les propriétés de conduction électronique des billes 7 peuvent, plus particulièrement, être modifiées en ajoutant des éléments dopant aux nanoparticules d'oxyde de zinc, afin de les rendre électriquement conductrices. Les éléments dopants sont, par exemple, des particules d'aluminium, de bore, de magnésium ou de chlore. Leur précurseur, solide ou liquide, est alors avantageusement ajouté dans le bain chimique 6. À titre d'exemple, un dopage à l'aluminium peut être obtenu en ajoutant dans le bain 6 du nitrate d'aluminium hydraté (Al(NO₃)₃H₂O).

À titre d'illustration, des nanofils verticaux en silicium sont réalisés sur un substrat formé par une plaquette en silicium, d'orientation cristalline <111> et de résistivité comprise entre 14 et 22 Ohm.cm. Ils sont, ensuite, traités par immersion dans un bain d'acétate de zinc et par recuit thermique.

En premier lieu, les nanofils en silicium sont synthétisés. Le substrat subit un nettoyage chimique dans un bain de H₂SO₄ (30%) et de H₂O₂ en proportion 2:1, pendant 10 minutes, puis un rinçage à l'eau désionisée pendant 5 minutes. Un nettoyage du substrat dans un bain d'HF (10%), suivi du même rinçage à l'eau sont ensuite effectués. Une couche d'aluminium de 10 nm d'épaisseur est ensuite déposée sur la surface du substrat ainsi préparée, par évaporation sous vide. Puis, des nanofils de silicium verticaux sont formés par dépôt chimique en phase vapeur (CVD). Les conditions de dépôt sont les suivantes :
- pression totale de l'enceinte de dépôt CVD : 0,040 MPa,
- température du substrat : 600 °C
- précurseurs gazeux : silane (SiH₄) et hydrogène (H₂) avec les pressions partielles suivantes : silane 866,6 Pa et hydrogène 0,0391 MPa
- durée du dépôt : 5 minutes.

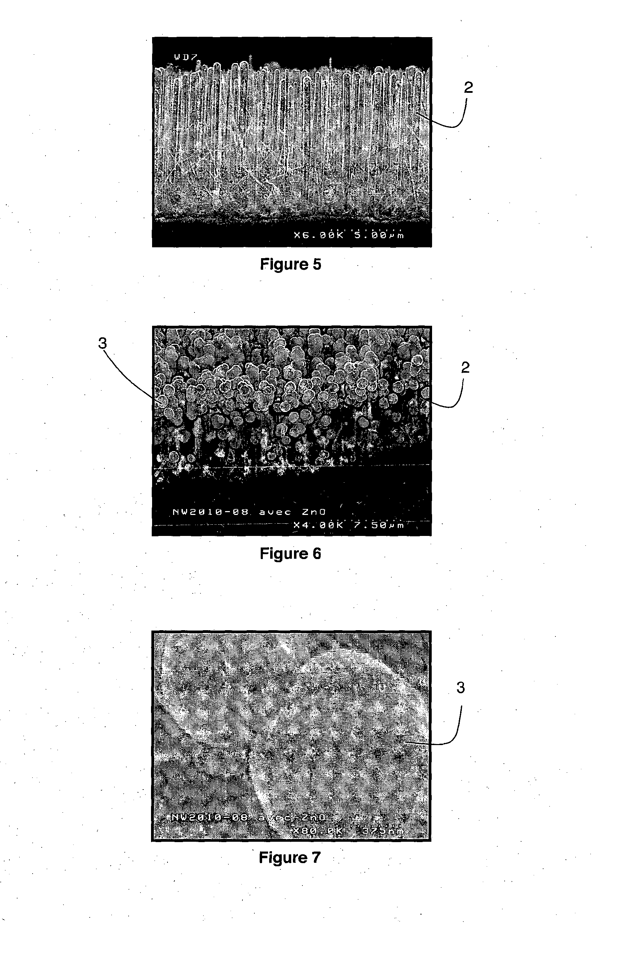

La structure ainsi obtenue a été caractérisée par microscopie électronique à balayage (figure 5). Les nanofils obtenus ont des diamètres compris entre 100nm et 600 nm, avec une distance moyenne entre deux nanofils de l'ordre de 3 µm et une longueur moyenne des nanofils de l'ordre de 15 µm.

En second lieu, les billes en ZnO sont formées à la surface des nanofils. Pour cela, la plaquette de silicium munie des nanofils verticaux est plongée dans un bain chimique, sans agitation, maintenu à 60°C et à pression atmosphérique. L'immersion est réalisée pendant 48 heures et le bain est constitué d'acétate de zinc (concentration 0,15 mol/L) dilué dans du méthanol.

Ensuite, la plaquette est retirée du bain chimique et elle subit directement un recuit thermique, à 450°C, pendant 10 minutes, sous air. Pour cela, elle est disposée sur une plaque chauffante. Une observation par microscopie électronique à balayage (figure 6) montre que la surface de chaque nanofils est recouvert d'environ 5 à 20 billes. De plus, le diamètre moyen de ces billes est compris entre 700 et 800nm. Par ailleurs, un grossissement plus important sur le cliché MEB représenté à la figure 7 montre que les billes sont composées par des agglomérats sphériques de particules nettement plus petites (typiquement 20nm).

Le fait de réaliser un dispositif comprenant une pluralité de nanofils et/ou de microfils, dont la surface est couverte de billes ayant un diamètre compris entre 100nm et 1µm et composées par des agglomérats sphériques de particules d'oxyde de zinc d'un diamètre compris entre 10nm et 200nm est avantageux notamment en termes d'amélioration de la tenue mécanique du dispositif et des performances optiques. De plus, les techniques pour sa mise en oeuvre (immersion dans un bain et recuit thermique) sont des techniques courantes, simples et peu coûteuses, permettant d'envisager une mise en oeuvre à l'échelle industrielle.

La présence des billes 3 assure effectivement une tenue mécanique au dispositif, ce qui améliore sa manipulation. En effet, les fils en matériau semi-conducteur de dimensions nanométriques ou micrométriques sont par nature fragiles. À titre d'exemple, la tenue mécanique d'une structure comprenant des nanofils de silicium avec des billes de ZnO a été testée et comparée à celle de la même structure sans billes de ZnO. Le test de tenue mécanique consiste à poser la structure sur une surface plane en dirigeant les nanofils vers ladite surface plane. Le support de la structure (typiquement la plaquette ou wafer en silicium) appuie alors sur les nanofils. Les structures ainsi manipulées ont ensuite été observées par microscopie électronique à balayage. Ces observations ont permis de constater que les nanofils de la structure ne contenant pas les billes en ZnO se sont cassés sous le poids du support, tandis que ceux de la structure avec les billes en ZnO sont restés intacts.

La présence des billes 3 en ZnO, lorsqu'elles sont réparties de façon homogène sur les fils, améliore aussi l'absorption de la lumière par les fils 2. En effet, les nanoparticules de ZnO et les billes 3 interagissent avec les rayonnements lumineux. Cette lumière est donc diffusée et elle peut donc être ainsi absorbée par les fils au lieu de traverser directement l'espace entre les fils. De plus, le spectre des longueurs d'onde pouvant être diffusées est élargi grâce à la présence de particules de deux dimensions différentes correspondant au diamètre des nanoparticules et des billes. La présence d'un agglomérat de nanoparticules permet donc une diffusion d'une plus grande gamme de longueurs d'onde que dans le cas des nanoparticules non agglomérées.

Enfin, le fait que des billes 3 en ZnO soient présentes dans les espaces 5 séparant les fils 2 est également avantageux, car cela permet d'augmenter la surface active optiquement du dispositif. L'espace séparant les fils n'est alors plus considéré comme un espace perdu.

Ces avantages sont, en particulier, très profitables pour la réalisation d'une cellule photovoltaïque, notamment inorganique, et employant un tapis de nanofils en silicium, germanium ou en un alliage Si-Ge.

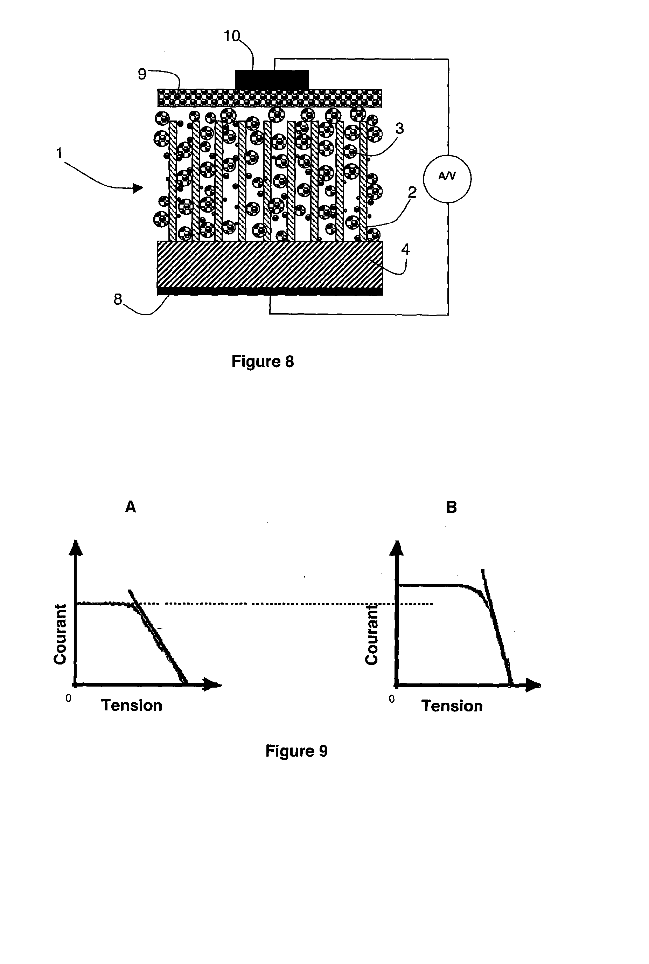

À titre d'exemple, une cellule photovoltaïque à jonction radiale en silicium a été réalisée. Sa structure est illustrée sur la figure 8. Après avoir réalisé une étape de croissance de nanofils 2 en silicium monocristallin, sur un substrat 4 en silicium fortement dopé, la jonction radiale est réalisée par un dépôt en phase vapeur assistée par plasma d'une couche en silicium amorphe hydrogéné. On obtient les nanofils 2 à jonction radiale. La croissance de billes 3 en ZnO dopé par de l'aluminium est effectuée en bain chimique avec la même méthode que celle décrite précédemment et en ajoutant un précurseur d'aluminium dans le bain. Dans ce mode de réalisation, les billes 3 en ZnO sont réparties de manière homogène le long des nanofils 2. Une électrode 8 en aluminium d'une épaisseur de 100nm est, ensuite, déposée sur la face arrière du substrat 4 par évaporation. Pour la face avant du substrat 4, on réalise un revêtement 9 en ZnO dopé par de l'aluminium d'une épaisseur de 500nm, par pulvérisation cathodique. Le revêtement 9 est alors disposé sur les sommets des nanofils 2 munis des billes 3. Enfin, une électrode métallique 10 en nickel/aluminium d'une épaisseur de 200nm est ensuite déposée sur le revêtement 9 par évaporation.

Les caractéristiques courant-tension de cette cellule (voir figure 9B) sont alors relevées et comparées à celles d'une même cellule sans billes 3 (voir figure 9A).

Sans billes 3 en ZnO, la pente de la courbe courant en fonction de la tension, sur la figure 9A, est faible. Ceci démontre une forte résistance série due au fait que les nanofils ne sont pas tous connectés entre eux et/ou que seul le sommet des nanofils est en contact avec l'électrode supérieure 10. De plus, on obtient un courant en circuit ouvert assez faible, car une part importante de la lumière passe entre les nanofils.

Avec les billes 3, on peut constater que la résistance série est fortement réduite, puisqu'elle passe de plusieurs centaines d'Ohms à quelques Ohms. Cette baisse de résistance est due au fait que les nanofils sont connectés entre eux et que les billes sont réparties de manière homogène le long des nanofils.

De plus, le courant en circuit ouvert est lui aussi amélioré, car une part importante de la lumière est diffusée par les billes en ZnO et absorbée par les fils. L'amélioration du courant résultant peut atteindre alors des valeurs entre 10% et 50 %, ce qui laisse présumer une amélioration du rendement de conversion énergétique pour la cellule photovoltaïque à nanofils (passage de 1% à 5-10% par l'ajout de nanoparticules de ZnO). De la tenue mécanique est améliorée.

Un dispositif à nanofils ou microfils tel que décrit ci-dessus peut être utilisé dans d'autres domaines que celui du photovoltaïque. Il peut notamment être utilisé dans des composants photoniques nécessitant une maximisation de photons. À titre d'exemple, il peut être utilisé dans un photodétecteur (ou photodiode) à nanofils, dans lequel une jonction est créée pour détecter la présence de photons. Le courant mesuré aux bornes du dispositif augmente alors lorsqu'un photon est absorbé. De plus, l'amélioration de la tenue mécanique d'une structure à nanofils ou microfils par la formation des billes en ZnO peut aussi être temporaire, dans un but de protéger la structure lors d'un transport. Dans ce cas, les billes sont ensuite éliminées par gravure humide sélective, typiquement dans un bain de NH₄Cl.

Ce dispositif peut aussi être utilisé pour sa seule fonction de conduction électrique. Il peut, par exemple, constituer une électrode (pour batterie, dispositif de production d'hydrogène,...).

## Revendications

1. Dispositif (1) comprenant une pluralité de fils (2) de dimensions nanométriques ou micrométriques et formés par un matériau semi-conducteur choisi parmi le silicium, le germanium et un alliage de silicium et de germanium, le dispositif comportant des billes (3) disposées à la surface des fils, characterisé en ce que les billes ont un diamètre compris entre 100nm et 1µm, et sont composées par des agglomérats sphériques de particules d'oxyde de zinc d'un diamètre compris entre 10nm et 200nm (2).

2. Dispositif (1) selon la revendication 1, **caractérisé en ce que** la surface des fils est amorphe.

3. Dispositif (1) selon l'une des revendications 1 et 2, **caractérisé en ce que** le diamètre des particules d'oxyde de zinc est compris entre 100nm et 200nm.

4. Dispositif selon l'une quelconque des revendications 1 à 3, **caractérisé en ce que** les fils (2) sont séparés les uns des autres par des espaces (5) dans lesquels est disposée au moins une partie des billes (3).

5. Dispositif selon la revendication 4, **caractérisé en ce que** les espaces (5) séparant les fils (2) adjacents ont une largeur moyenne comprise entre 100nm et 15 µm.

6. Dispositif selon l'une quelconque des revendications 1 à 5, **caractérisé en ce que** des fils (2) adjacents sont mis en contact entre eux par l'intermédiaire des billes (3).

7. Dispositif selon l'une quelconque des revendications 1 à 6, **caractérisé en ce que** les fils (2) sont supportés par un substrat (4) en matériau semi-conducteur ou métallique.

8. Dispositif selon l'une quelconque des revendications 1 à 7, **caractérisé en ce que** les particules d'oxyde de zinc comportent un élément dopant les rendant électriquement conductrices.

9. Procédé de réalisation d'un dispositif selon l'une quelconque des revendication 1 à 8, **caractérisé en ce que** les billes (3) sont formées à la surface des fils (2) par les étapes suivantes :
- immersion des fils (2) dans un bain (6) contenant un solvant alcoolique et de l'acétate de zinc, dans des conditions de température et de pression maintenant le solvant alcoolique à l'état liquide,
- et recuit thermique des fils (2) après leur retrait du bain (6), transformant l'acétate de zinc en oxyde de zinc.

10. Procédé selon la revendication 9, **caractérisé en ce que** l'étape d'immersion est réalisée dans une enceinte scellée, à pression atmosphérique, en maintenant le bain à une température comprise entre -10°C et +65°C.

11. Procédé selon l'une des revendications 9 et 10, **caractérisé en ce que** la durée de l'étape d'immersion est comprise entre 2 heures et 48 heures.

12. Procédé selon l'une quelconque des revendications 9 à 11, **caractérisé en ce que** l'étape de recuit thermique est réalisée à une température comprise entre 300°C et 600°C.

13. Procédé selon l'une quelconque des revendications 9 à 12, **caractérisé en ce qu'**au moins une partie des fils (2) est formée de fils cristallins et **en ce que** la surface des fils cristallins est oxydée au contact de l'air avant l'étape d'immersion.

14. Procédé selon l'une quelconque des revendications 9 à 12, **caractérisé en ce qu'**une couche en matériau semi-conducteur amorphe est déposée sur la surface d'au moins une partie des fils.

15. Procédé selon l'une quelconque des revendications 9 à 12, **caractérisé en ce qu'**au moins une partie des fils est formée par une opération de gravure dans une couche constituée par le matériau semi-conducteur.

16. Utilisation d'un dispositif selon l'une quelconque des revendications 1 à 8 dans une cellule photovoltaïque.

17. Utilisation d'un dispositif selon l'une quelconque des revendications 1 à 8 dans un composant photonique.

## Patentansprüche

1. Vorrichtung (1), umfassend eine Vielzahl von Drähten (2) mit Nanometer- oder Mikrometer-Abmessungen, die durch ein Halbleitermaterial, welches aus Silizium, Germanium und einer Sitizium-Germanium-Legierung ausgewählt ist, gebildet sind, wobei die Vorrichtung Kugeln (3), die an der Oberfläche der Fäden angeordnet sind, umfasst, **dadurch gekennzeichnet, dass** die Kugeln einen Durchmesser im Bereich zwischen 100 nm und 1 µm aufweisen und durch kugelförmige Agglomerate aus Zinkoxidpartikeln mit einem Durchmesser im Bereich zwischen 10 nm und 200 nm (2) gebildet sind.

2. Vorrichtung (1) nach Anspruch 1, **dadurch gekennzeichnet, dass** die Oberfläche der Drähte amorph ist.

3. Vorrichtung (1) nach einem der Ansprüche 1 und 2, **dadurch gekennzeichnet, dass** der Durchmesser der Zinkoxidpartikel zwischen 100 nm und 200 nm beträgt.

4. Vorrichtung nach einem der Ansprüche 1 bis 3, **dadurch gekennzeichnet, dass** die Drähte (2) durch Zwischenräume (5), in denen wenigstens ein Teil der Kugeln (3) angeordnet ist, voneinander getrennt sind.

5. Vorrichtung nach Anspruch 4, **dadurch gekennzeichnet, dass** die die benachbarten Drähte (2) trennenden Zwischenräume (5) eine mittlere Breite im Bereich zwischen 100 nm und 15 µm aufweisen.

6. Vorrichtung nach einem der Ansprüche 1 bis 5, **dadurch gekennzeichnet, dass** benachbarte Drähte (2) mittels der Kugeln (3) untereinander in Kontakt gebracht sind.

7. Vorrichtung nach einem der Ansprüche 1 bis 6, **dadurch gekennzeichnet, dass** die Drähte (2) durch ein Substrat (4) aus Halbleiter- oder metallischem Material getragen sind.

8. Vorrichtung nach einem der Ansprüche 1 bis 7, **dadurch gekennzeichnet, dass** die Zinkoxidpartikel ein Dotierungselement, das sie elektrisch leitend macht, umfassen.

9. Verfahren zur Herstellung einer Vorrichtung nach einem der Ansprüche 1 bis 8, **dadurch gekennzeichnet, dass** die Kugeln (3) an der Oberfläche der Drähte (2) durch die folgenden Schritte gebildet werden:
- Eintauchen der Drähte (2) in ein ein alkoholisches Lösungsmittel und Zinkacetat enthaltendes Bad (6), unter Temperatur- und Druckbedingungen, die das alkoholische Lösungsmittel in flüssigem Zustand halten, und
- thermisches Glühen der Drähte (2) nach ihrem Herausnehmen aus dem Bad (6), das das Zinkacetat in Zinkoxid umwandelt.

10. Verfahren nach Anspruch 9, **dadurch gekennzeichnet, dass** der Eintauchschritt in einem geschlossenen Raum, bei atmosphärischem Druck, unter Halten des Bades auf einer Temperatur zwischen -10 °C und +65 °C durchgeführt wird

11. Verfahren nach einem der Ansprüche 9 und 10, **dadurch gekennzeichnet, dass** die Dauer des Eintauchschrittes zwischen 2 Stunden und 48 Stunden beträgt.

12. Verfahren nach einem der Ansprüche 9 bis 11, **dadurch gekennzeichnet, dass** der Schritt des thermischen Glühens bei einer Temperatur zwischen 300 °C und 600 °C durchgeführt wird.

13. Verfahren nach einem der Ansprüche 9 bis 12, **dadurch gekennzeichnet, dass** wenigstens ein Teil der Drähte (2) von kristallinen Drähten gebildet ist und dass die Oberfläche der kristallinen Drähte vor dem Eintauchschritt bei Kontakt mit der Luft oxidiert wird.

14. Verfahren nach einem der Ansprüche 9 bis 12, **dadurch gekennzeichnet, dass** eine Schicht aus amorphem Halbleitermaterial auf der Oberfläche wenigstens eines Teils der Drähte abgeschieden wird.

15. Verfahren nach einem der Ansprüche 9 bis 12, **dadurch gekennzeichnet, dass** wenigstens ein Teil der Drähte durch einen Ätzvorgang in einer durch das Halbleitermaterial gebildeten Schicht gebildet wird.

16. Verwendung einer Vorrichtung nach einen der Ansprüche 1 bis 8, in einer Photovoltaikzelle.

17. Verwendung einer Vorrichtung nach einem der Ansprüche 1 bis 8, in einem photonischen Bauelement.

## Claims

1. A device (1) comprising a plurality of wires (2) of nanometric or micrometric dimensions and formed by a semiconductor material chosen from silicon, germanium and a silicon-germanium alloy, the device comprising pellets (3) arranged at the surface of the wires, **characterized in that** the pellets have a diameter comprised between 100nm and 1 µm, and are formed by spherical agglomerates of zinc oxide particles with a diameter comprised between 10nm and 200nm.

2. The device (1) according to claim 1, **characterized in that** the surface of the wires is amorphous.

3. The device (1) according to one of claims 1 and 2, **characterized in that** the diameter of the zinc oxide particles is comprised between 100nm and 200nm.

4. The device according to any one of claims 1 to 3, **characterized in that** the wires (2) are separated from one another by spaces (5) in which at least a part of the pellets (3) are arranged.

5. The device according to claim 4, **characterized in that** the spaces (5) separating adjacent wires (2) have a mean width comprised between 100nm and 15 µm.

6. The device according to any one of claims 1 to 5, **characterized in that** adjacent wires (2) are placed in contact with one another through the pellets (3).

7. The device according to any one of claims 1 to 6, **characterized in that** the wires (2) are supported by a substrate (4) made from semiconductor or metallic material.

8. The device according to any one of claims 1 to 7, **characterized in that** the zinc oxide particles comprise a doping element making them electrically conductive.

9. A method for producing a device according to any one of claims 1 to 8, **characterized in that** the pellets (3) are formed at the surface of the wires (2) by the following steps:
- immersing the wires (2) in a bath (6) containing an alcohol-based solvent and zinc acetate, under temperature and pressure conditions keeping the alcohol solvent in the liquid state,
and thermal annealing of the wires (2) after removal of the latter from the bath (6), transforming the zinc acetate into zinc oxide.

10. The method according to claim 9, **characterized in that** the immersion step is performed in a sealed enclosure, at atmospheric pressure, keeping the bath at a temperature comprised between -10°C and +65°C.

11. The method according to one of claims 9 and 10, **characterized in that** the duration of the immersion step is comprised between 2 hours and 48 hours.

12. The method according to any one of claims 9 to 11, **characterized in that** the thermal annealing step is performed at a temperature comprised between 300°C and 600°C.

13. The method according to any one of claims 9 to 12, **characterized in that** at least a part of the wires (2) are formed by crystalline wires and **in that** the surface of the crystalline wires is oxidized in contact with air before the immersion step.

14. The method according to any one of claims 9 to 12, **characterized in that** a layer of amorphous semiconductor material is deposited on the surface of at least a part of the wires.

15. The method according to any one of claims 9 to 12, **characterized in that** at least a part of the wires are formed by an etching operation in a layer formed by the semiconductor material.

16. The use of a device according to any one of claims 1 to 8 in a photo-voltaic cell.

17. The use of a device according to any one of claims 1 to 8 in a photonic component.
